# EUROPEAN PATENT SPECIFICATION

(11) **EP 3 144 668 B1**
(45) Date of publication and mention of the grant of the patent: **24.04.2024**
(21) Application number: 16196622.1
(22) Date of filing: 30.05.2013
(51) Int. Cl.: G01N 27/04, G01N 27/22

(54) **SYSTEM AND METHOD FOR FLUID SENSING IN A DIAPER**
SYSTEM UND VERFAHREN ZUR FLÜSSIGKEITSDETEKTION IN EINER WINDEL
SYSTÈME ET PROCÉDÉ DE DÉTECTION DE LIQUIDES DANS UNE COUCHE

(30) Priority: 30.05.2012 US 201261653071 P; 30.05.2012 US 201261653307 P; 30.05.2012 US 201261653310 P; 30.05.2012 US 201261653313 P; 22.10.2012 US 201261717032 P
(43) Date of publication of application: 22.03.2017
(62) Divisional of application: 13797057.0
(73) Proprietor: Abena Holding A/S, 6200 Aabenraa (DK)
(72) Inventor: RAUT,, Nitin, Sunnyvale, CA California 94086 (US); STEVENS,, Luke, Santa Clara, CA California 95051 (US)
(74) Representative: Mewburn Ellis LLP

(56) References cited:
- WO-A1-2008/130149
- WO-A2-2008/115987
- FR-A1- 2 669 529
- US-A- 5 537 095
- US-A1- 2007 252 713
- US-A1- 2007 270 774

## Description

### BACKGROUND

The use of sensors is a well known practice to gather a wide variety of data measuring properties of substances. For example, sensors may be operable to sense the presence of certain substances, calculate the volume of a substance, identify a substance, determine physical characteristics of a substance, or the like.

Sensors may be used in medical applications to sense bodily fluids such as blood, urine or perspiration. Unfortunately, conventional fluid sensors fail to provide for accurate and cost-effective sensing of fluids, and are unable to be adapted to specialized sensing environments such as medical applications. Accordingly, improved fluid sensors, methods of calibrating fluid sensors, and methods of obtaining data from fluid sensors are needed in the art.

### SUMMARY

In a first aspect, the invention provides a diaper with a liquid sensing system comprising: a sensor array comprised of a set of elongated and flat uniformly shaped conducting lines, wherein the conducting lines are uniform in shape and substantially parallel extending along an inner surface of a moisture barrier layer, wherein the sensor array has a measured gradient of conductance in a dry state, wherein a pair of the conducting lines define an array sensing region that is configured for measuring a gradient of conductance values in the sensing region upon a presence of a liquid contained by the moisture barrier layer; a data acquisition unit operably connected to the sensor array comprising signal processing elements, wherein the data acquisition unit comprises a multiplexer configured for receiving analog voltage signals from the array sensing region of the array and measuring the gradient of conductance values between each of the pair of conducting lines defining the array sensing region, a read circuit configured for measuring the voltage signals, and an analog to digital converter configured for converting the voltage signals to numeric representation and combinations thereof.

In some embodiments, the pair of conducting lines define a sensing region there between, preferably wherein there is a storable data identifier unique to the array sensing region.

In some embodiments, the data acquisition unit is connected by wire to the sensor array to a user device.

In some embodiments, the data acquisition unit stores sensed conductance gradient values.

In some embodiments, the diaper further comprises a network connection to a user device selected from a group consisting of a tablet, a smart phone, and a computer.

In some embodiments, the diaper further comprises a fluid active material disposed in proximity to the sensor array to alter electrical characteristics of the fluid contained by the moisture barrier layer.

In some embodiments, the array sensing region measures a gradient of dry state conductance values and a gradient of wet state conductance values_in the sensing region upon a presence of a liquid contained by the moisture barrier layer.

In a second aspect, the invention provides a method for detection of liquid disposed in a diaper, the method comprising: operably connecting a data acquisition unit to the diaper which comprises a moisture barrier layer; sensing array conductance in a dry state by measuring a gradient of conductance values in an array sensing region of substantially parallel conducting lines disposed along a surface of the moisture barrier layer and storing the sensed array conductance in the dry state, wherein an area between a pair of conducting lines defines a sensing region; computing and storing a total sensed array conductance in the dry state; detecting a change in the gradient of conductance values at a plurality of the sensing regions in the array sensing region in response to the presence of a liquid; computing and storing a total sum of sensed conductance in the wet state; using a transfer curve to determine a liquid volume from the total, stored sensed conductance in the wet state; wherein the gradient of conductance values of the conducting lines are communicated to the data acquisition unit such that each of the plurality of sensing regions has a storable data identifier, and wherein a detectable signal is processed in the data acquisition unit; storing sensed data from a array sensing region having the storable data identifier; repeating each of the measuring, detecting, and storing steps for a plurality of the sensing regions of the array sensing region; and calculating a volume of liquid contained by the moisture barrier layer based on the gradient of conductance values detected at the plurality of sensing regions in the array sensing region and communicated to the data acquisition unit from the array.

In some embodiments, the measuring, detecting and storing steps comprise a sensing session and the method further comprises the step of determining whether the sensing session is complete or repeated.

In some embodiments, the calculating step is further comprised of determining whether a threshold fluid limit is met, preferably wherein the step of calculating a volume of liquid contained by the moisture barrier layer is comprised of measuring real time, sensed gradient conductance values against a calibrated reference value.

In some embodiments, the measuring step is comprised of measuring the gradient of conductance values in the array sensing region in a dry state and storing the dry state value, or measuring a gradient of conductance values in a plurality of wet states, preferably further comprising the step of storing a total sum of the plurality of wet state conductance values.

In some embodiments, the method further comprises the step of calculating a surface area of the array sensing region where liquid is present, preferably wherein the calculation of surface area is combined with the calculation of volume to yield a value for volume of liquid in a selected surface area.

In some embodiments, the data acquisition unit further comprises a multiplexer, wherein the multiplexer obtains a signal from the array sensing region, provides the signal to a read circuit, and converts the signal from analog to digital with an analog to digital converter.

### BRIEF DESCRIPTION OF THE DRAWINGS

Fig. 1a is an exemplary top view drawing illustrating a sensor array which is not claimed.
Fig. 1b is an exemplary first side view drawing illustrating the sensor array in Fig 1a.
Fig. 1c is an exemplary close-up of the sensor array depicted in Fig. 1b.
Fig. 1d is an exemplary second side view drawing illustrating the sensor array in Fig 1a.
Fig. 1e is an exemplary close-up of the sensor array depicted in Fig 1d.
Fig. 2a is an exemplary top view drawing illustrating an embodiment of a sensor array.
Fig. 2b is an exemplary first side view drawing illustrating the embodiment of the sensor array in Fig 2a.
Fig. 3 is an exemplary top view drawing illustrating another sensor array which is not claimed.
Fig. 4 an exemplary top view drawing illustrating a further sensor array which is not claimed.
Fig. 5 is top-level drawing depicting an embodiment of a system for fluid sensing.
Fig. 6 is a block diagram illustrating an embodiment of a data acquisition unit.
Fig. 7 is an exemplary flow chart illustrating an embodiment of a method for moisture sensing.
Fig. 8 is an exemplary flow chart illustrating a method for calibrating a moisture sensor.
Fig. 9 is an exemplary flow chart illustrating another method for calibrating a moisture sensor.
Fig. 10a depicts a method of determining fluid volume in accordance with one embodiment.
Fig. 10b depicts another method of determining fluid volume.

It should be noted that the figures are not drawn to scale and that elements of similar structures or functions are generally represented by like reference numerals for illustrative purposes throughout the figures. It also should be noted that the figures are only intended to facilitate the description of the preferred embodiments. The figures do not illustrate every aspect of the described embodiments and do not limit the scope of the present disclosure.

### DETAILED DESCRIPTION OF THE PREFERRED EMBODIMENTS

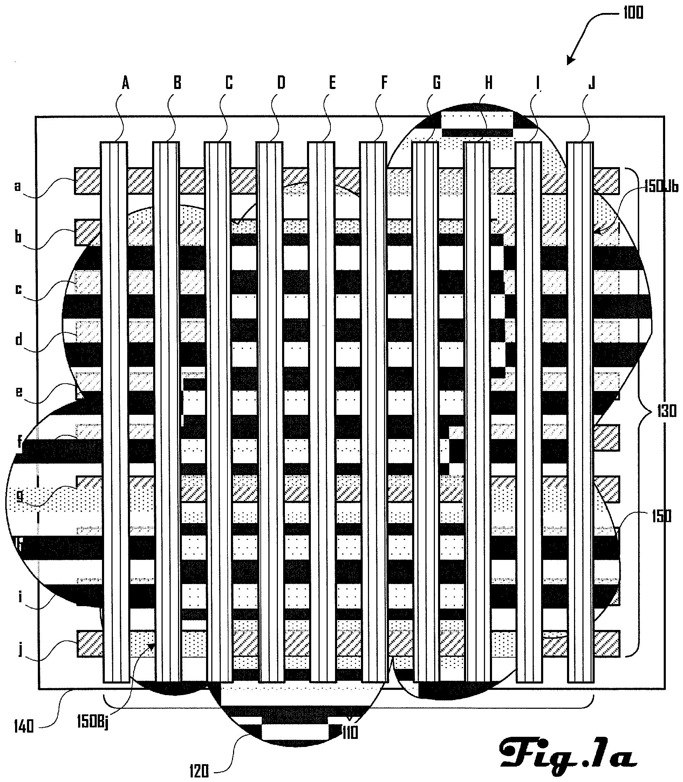

Since currently-available moisture systems fail to effectively provide for accurate detection of fluid, improved systems and methods that provide for moisture sensing can prove desirable and provide a basis for a wide range of applications, such as providing a value for fluid volume present, providing a value for surface area where fluid is present, providing a determination of the identity, class or characteristic of a fluid, and providing for detection of motion, position or other characteristic of a subject wearing such a sensor. Such results can be achieved by a moisture sensing array 100 as illustrated in Figs. 1a - 1e.

The moisture sensing array 100 comprises a first and second set of conducting lines 110, 130 with a fluid layer 120 disposed between the first and second set of conducting lines 110, 130. A fluid barrier layer 140 is disposed facing the second set of conducting lines 130 and a buffer layer 160 may be disposed facing the first set of conducting lines 110.

Accordingly, a portion of the moisture sensing array 100 may be defined by plurality of layers. The buffer layer 160 may be layered facing the first set of conducting lines 110 with the first set of conducting lines 110 being layered between the fluid layer 120 and the buffer layer 160. The fluid layer 120 can be layered between the first and second conducting lines 110, 130. The second set of conducting lines 130 may be layered between the fluid layer 120 and the fluid barrier layer 140. The fluid barrier layer 140 may be layered facing the second set of conducting lines 130.

The first set of conducting lines 110 may be spaced apart, substantially parallel and extend in a first direction and the second set of conducting lines 130 may be spaced apart, substantially parallel and extend in a second direction that is substantially perpendicular to the first direction of the first set of conducting lines 110. Each of the conducting lines of the first set 110 may disposed proximate to each of the conducting lines of the second set 130, which defines a plurality of sensing regions 150. Each sensing region 150 may be defined by a region where one of the first and second set of conducting lines 110, 130 are proximate and defined by a portion of the fluid layer 120.

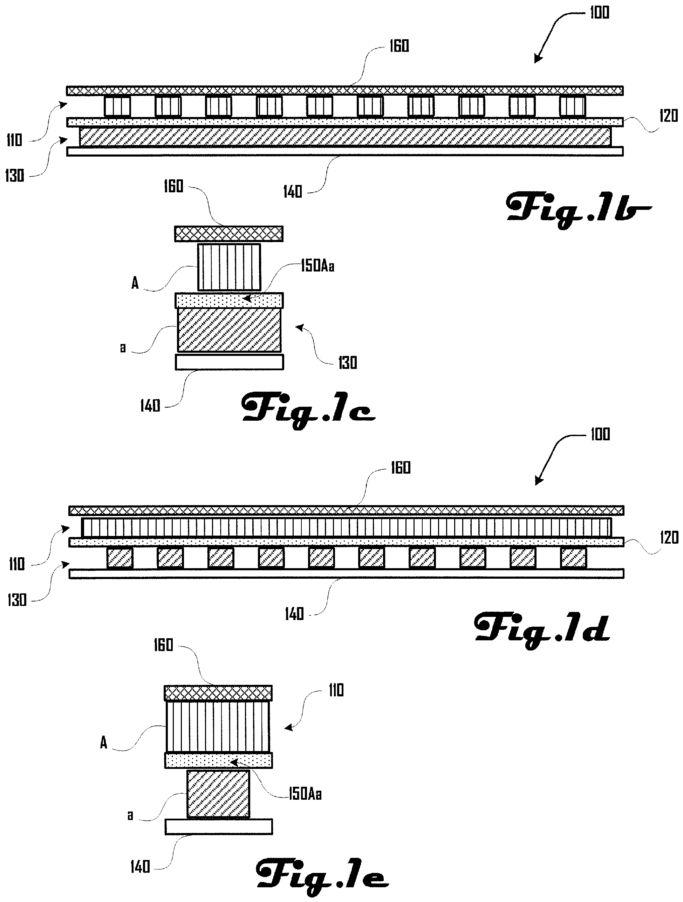

For example, Fig. 1 depicts the first set of conducting lines 110 labeled capital A-J and the second set of conducting lines 130 labeled lower case a-j. Sensing region 150Jb is defined by the proximate junction of conducting line "J" and conducting line "b"; sensing region 150Bj is defined by the proximate junction of conducting line "B" and conducting line "j"; and sensing region 150Aa is defined by the proximate junction of conducting line "A" and conducting line "a" as depicted in Figs. 1c and 1e. The plurality of sensing regions 150 can collectively define a sensing array of sensing regions 150.

The first and second set of conducting lines 110, 130 may comprise any suitable conductive material, and may be any suitable size or shape. For example, the conducting lines 110, 130 may be elongated and flat, rounded, rectangular or the like. Additionally, the conducting lines 110, 130 may of uniform or non-uniform size, shape, material or spacing. While various depicted disclosures depict conducting line sets 110, 130 having ten lines each, a moisture sensing array 100 may have any suitable number of conducting lines in a set, either uniform or non uniform.

The moisture sensing array 100 may be flexible or rigid. For example, it may be desirable for the moisture sensing array 100 to be flexible so that the array 100 can confirm to various shapes. In some embodiments, the array 100 may define a portion of bedding, a diaper, a bandage, pants, a shirt, a hat, socks, and gloves, or the like. As discussed in more detail herein, this may be desirable so that moisture generated by a human subject may be sensed and tracked in terms of either volume, surface area, and/or position on the array.

The fluid layer 120 may be a material operable to change in electrical properties(s) (e.g., resistive properties, capacitive properties, or inductive properties) in response to the presence of a fluid such as a liquid or gas. For example, the fluid layer 120 may comprise a polyaniline-based conducting polymer doped with weak acid dopants.

The fluid barrier layer 140 may be a material that is impermeable to various fluids. For example, the fluid barrier layer 140 may configured to be impermeable to a fluid that affects one or more electrical properties(s) of the fluid layer 120. This may be desirable because the fluid barrier layer 140 may thereby hold a target fluid in the fluid layer 120 to enable measurement and/or sensing of the fluid as described herein.

The buffer layer 160 may comprise a material that provides a holding capacity for a fluid within the fluid barrier layer 140. The material of the buffer layer 160 may be selected with a desired moisture holding capacity so as to extend the active sensing range of the array 100. The buffer layer 160 may provide an entry for fluid into the array 100 and into the fluid layer 120.

The buffer layer 140 may provide for fluid conditioning. For example, the buffer layer 140 may be configured to filter out particulate matter, may be configured to remove matter dissolved in a fluid, may be configured to separate one type or class of fluid from another, or the like.

The buffer layer 140 may also serve as a comfort layer when the array 100 is used by a subject. For example, where the array is incorporated into objects such as bedding, a diaper, a bandage, pants, a shirt, a hat, socks, or gloves, it may be desirable for the buffer layer to comprise a soft material so that wearability of the article is improved.

For example, the array 100 may be substantially planar with the buffer layer 160 in contact with the skin of a human subject. When the subject sweats (i.e., excretes fluid), the fluid can pass into the buffer layer 160 and into the fluid layer 120, where the sweat fluid is sensed and quantified as described herein.

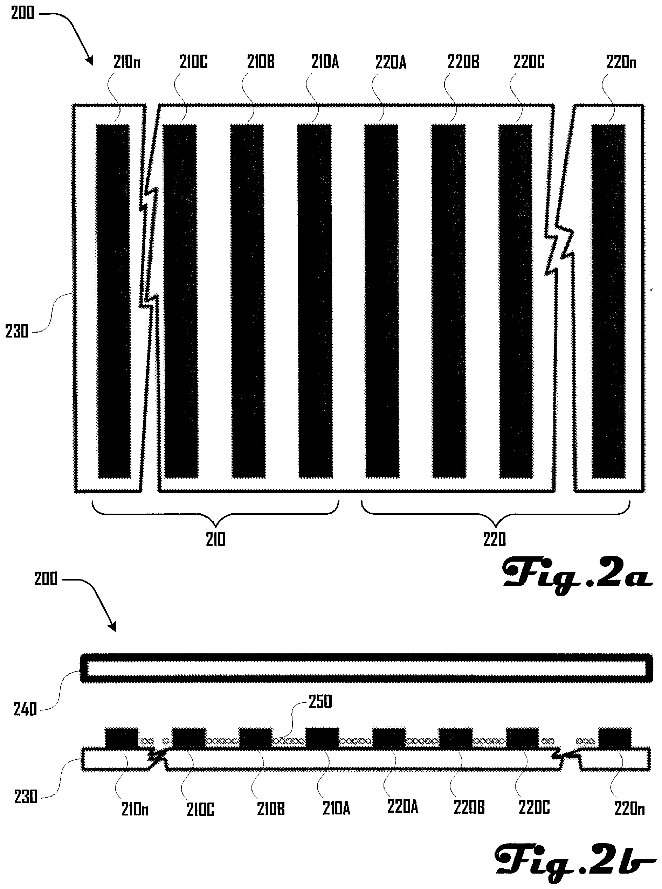

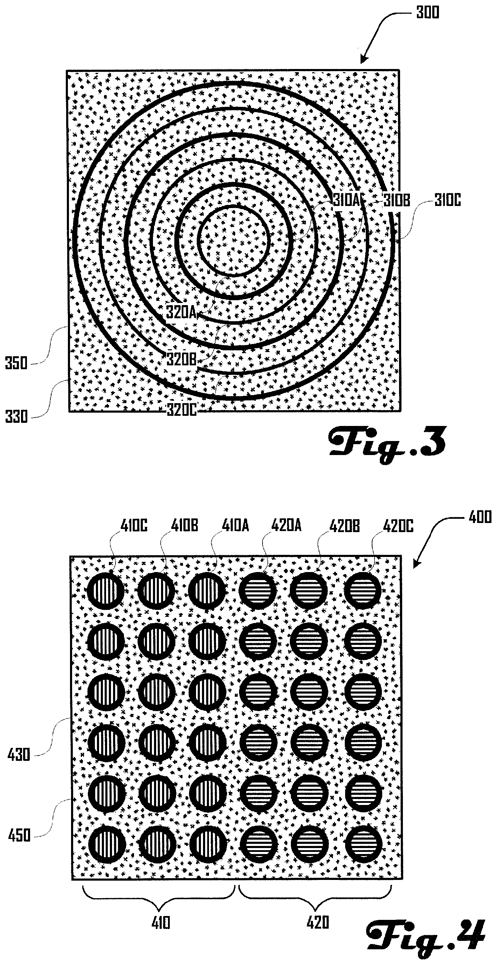

Figs. 2a and 2b depict a moisture sensing array 200 in accordance with further embodiments. Figs. 3 and 4 depict moisture sensing arrays 300 and 400.

Turning to Figs. 2a and 2b, the moisture sensing array 200 comprises a moisture barrier layer 230 with a first set of conducting lines 210 disposed on one side of the moisture barrier layer 230, and a second set of conducting lines 220 disposed on another side of the moisture barrier layer 230. The first set of conducting lines 210 is labeled as lines 210A-210n and the second set of conducting lines 220 is labeled as 220A-n. As depicted in Fig. 2b, the array 200 may comprise a buffer layer 240.

Further disposed on the moisture barrier layer 230 and between each of the conducting lines 210, 220 is a fluid activated material 250, which may comprise a plurality of conductive particles that change in electrical characteristic(s) when exposed to a fluid. For example, the fluid activated material 250 may be non-conducting or of fixed conductance in a dry state, and the conductance of the material 250 may change when wet. This may be desirable in embodiments where detection of a non-conductive fluid is required.

Fig. 3 depicts a moisture sensing array 300 comprising a plurality of concentric electrodes 310, 320 having a fluid activated material 350 disposed therebetween, with the electrodes 310, 320 and material 350 disposed on a moisture barrier layer 330. First and second sets of electrodes 310, 320 may be alternated concentrically. For example, as shown in Fig. 3, the largest electrode 310C may be proximate to smaller electrode 320C, with smaller electrode 320C proximate to still smaller electrode 310B. Similarly, smallest electrode 320A may be proximate to next smallest electrode 310A, which is proximate to third smallest electrode 320B.

Fig. 4 depicts a fluid sensing array 400 comprising a plurality of electrodes 410, 420 disposed on a fluid barrier 430 with a fluid activated material 450 disposed on the fluid barrier 430 between the electrodes 410, 420. The electrodes 410, 420 may be grouped in columns and rows, with the first set of electrodes 410 on one portion of the fluid barrier 430 and the second set of electrodes 420 on another portion of the fluid barrier 430. For example, one row may sequentially include three first electrodes 410C, 410B, 410A and then three second electrodes 420A, 420B, 420C.

The example embodiment of a sensor array 200 depicted herein should not be construed to limit the possibility of further embodiments.

In some embodiments any of the components may be absent, or may be present in plurality. For example, in some embodiments a buffer layer 240 may be absent. For example, in some disclosures a buffer layer 160 may be absent. In another disclosure, there may be a plurality of conducting line sets 110, 120. In a still further disclosure, a plurality of sensor arrays 100 and/or conducting line sets 110, 120 may be layered together. In yet another disclosure, the fluid layer may be absent 120, when conductive fluids such as blood, urine or the like is desired for detection.

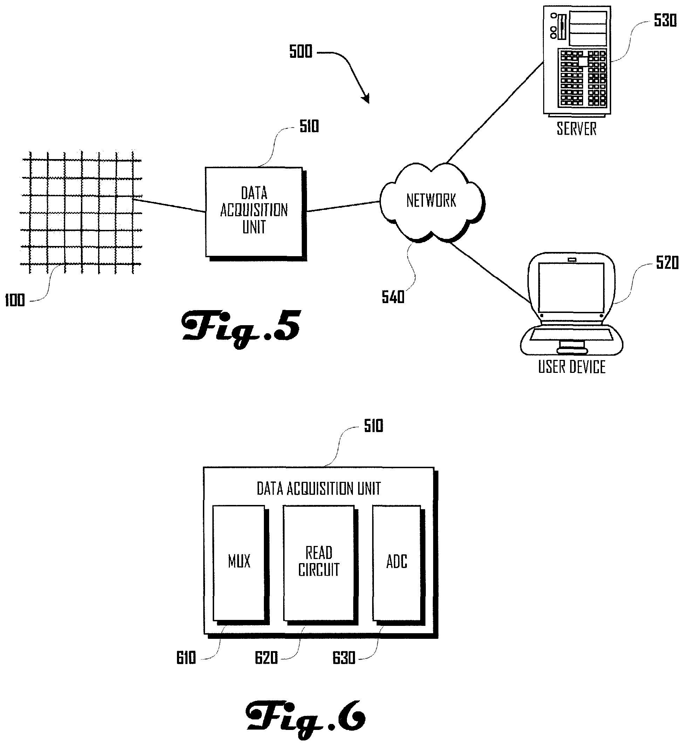

Turning to Fig. 5, a moisture sensing system 500 is shown as including at least one sensor array 100 operably connected to a data acquisition unit 510, a user device 520, and a server 530 that are operably connected via a network 540.

The user device 520, server 530, and network 540 each can be provided as conventional communication devices of any type. For example, the user device 520 may be a laptop computer as depicted in Fig. 5; however, in various embodiments, the user device 520 may be various suitable devices including a tablet computer, smart-phone, desktop computer, gaming device, or the like without limitation.

Additionally, the server 530 may be any suitable device, may comprise a plurality of devices, or may be a cloud-based data storage system. The network 540 may comprise one or more suitable wireless or wired networks, including the Internet, a local-area network (LAN), a wide-area network (WAN), or the like. Additionally, the sensor array 100 can be operably connected to a data acquisition unit 510 via one or more wire, wirelessly, via a network like the network 540, or via the network 540.

There may be a plurality of any of the user device 520, the server 530, data acquisition unit 510, or sensor array 100. For example, there may be a plurality of users that are associated with one or more user devices 520, and the users (via user devices 520) and the server 530 may communicate with or interact with one or more data acquisition unit 510 and sensor array 100. Data obtained from the sensor array 100 or data acquisition unit 510 may be processed and or stored at the user device 520, server 530, or the like.

Fig. 6 is a block diagram illustrating an embodiment of the data acquisition unit 510 depicted in Fig. 5, which comprises a multiplexer 610, a read circuit 620 and an analog-to-digital converter 630. The multiplexer 510 may obtain a signal (*e.g.,* an analog voltage) from the array 100 and provide the signal to the read circuit 620, and the read signal can be converted to a digital signal by the analog-to-digital converter 630 and the digital signal may be provided to a computation point, which may include one or both of the user device 520, server 530 or any other suitable computation device. In some embodiments, computation may occur at the data acquisition unit 510.

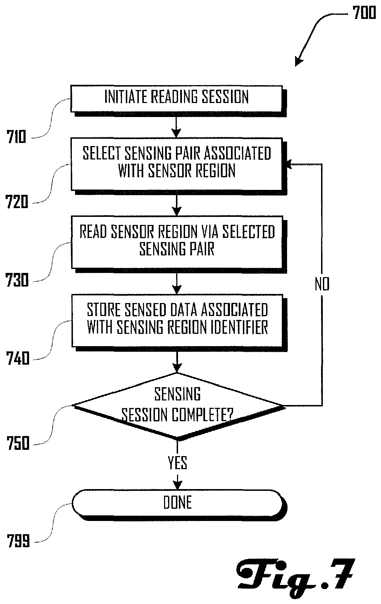

Fig. 7 is an exemplary flow chart illustrating a method 700 for fluid sensing. The method 700 begins in block 710, where a reading session is initiated, and in block 720 a sensing line pair associated with a sensing region 150 is selected. For example, referring to Figs. 1a, 1c and 1e the line "A" and line "a" may be selected, which are associated with sensing region 150Aa.

In block 730, the sensing region 150 is read via the selected sensor pair. For example, a conductance may be measured at the sensing region 150Aa via line "A" and line "a." In block 740, sensed data is associated with a sensing region identifier and stored. Data may be stored in a matrix, table, array or via any other suitable data storage method. In block 750 a determination is made whether the sensing session is complete, and if so, the method 700 ends in block 799; however, if the sensing session is not complete then the method 700 cycles back to block 720.

For example, it may be desirable to read some or all of the sending regions 150 of a moisture sensing array 100, during a sensing session so that the set of readings can be used to quantify and sense fluid across the sensing array 100. A sensing session comprising a plurality of selected sensing regions 150 may have a sensing order selected randomly or may be pre-selected. In some embodiments, the sensing order may be uniform, such as up or down rows, or the like. In further embodiments, a sensing order may be non-uniform. In the context of Fig. 7, a sensing session will read all sensing regions 150 in a sensing order or randomly, and the sensing session will end when all desired sensing regions 150 have been read. Accordingly, selecting a sensor pair associated with a sensor region in block 720 may include selecting a sequential sensing regions 150 from a list, selecting random sensing regions from a set of unread desired sensing regions or the like.

In some embodiments, reading a sensor may be binary or may provide for a gradient of values. For example, binary sensing may comprise a determination of whether a threshold fluid limit has been met, and if so, fluid is indicated as being present, whereas if the threshold is not met, then the fluid is indicated as being not present.

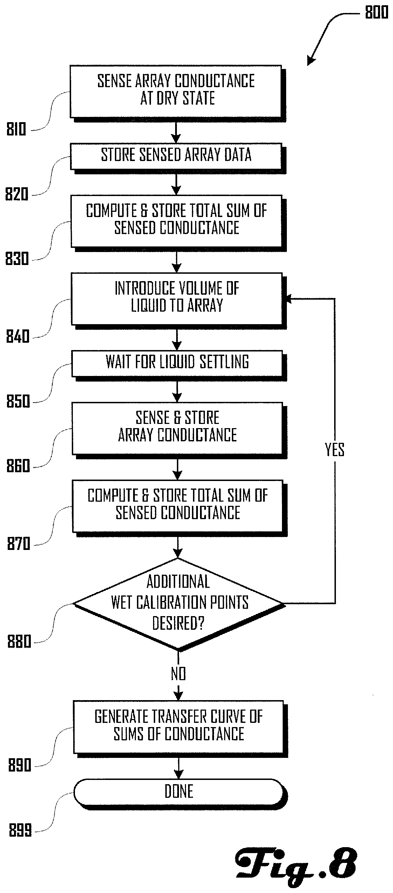

Fig. 8 is an exemplary flow chart illustrating a method 800 for calibrating a fluid sensor 100. The method begins in block 810, where the conductance of an array 100 is sensed at a dry state. For example, the conductance of the array 100 may be sensed via the sensing method 700 of Fig. 7. Other electrical characteristics such as resistance or capacitance may be measured in addition or alternatively.

Returning to Fig. 8, the sensed array data is stored in block 820, and in block 830, a total sum of the sensed conductance is computed and stored. In block 840, a volume of liquid is introduced to the array 100 and a time period is allowed to lapse, which provides for liquid settling in block 850. A settling time may be chosen based on the properties of various components of an array 100, including the buffer layer 160, conducting lines 110, 130, the fluid layer 120, or the like.

In block 860, array conductances are sensed in a wet state and stored, and in block 870, a total sum of the sensed conductances is computed and stored. In decision block 880, a determination is made whether additional wet calibration points are desired, and if so, the method 800 cycles back to block 840, where a further volume of liquid is introduced to the array 100. However, if no further additional wet calibration points are desired, then the method 800 continues to block 890 where a transfer curve of the sums of conductance is generated, and in block 899, the method 800 is done.

For example, it may be desirable to generate a transfer function that indicates the array's sum of conductance in a dry state and in a plurality of wet states. The total sum of conductance can be calculated with the array 100 in a dry state in block 830, and sequential volumes of liquid can be added to the array 100 to generate a set of total sum conductances at various volumes of liquid. The amount of liquid introduced at each successive introduction may be constant or may be variable. For example, 5mL may be added each time, or increasing or decreasing amounts of liquid may be added sequentially as desired.

One example of a transfer function is a linear model polynomial having the form T₁(x) = p₁*x + p₂, where x is the conductance is computed using total sum of conductance f₁*(m, n).* In such an example, coefficients (with 95% confidence) may be pi = 0.00255 (0.002362, 0.002739) and pz = -5.141 (-6.828, -3.453). The transfer function may be embodied in an equation or a lookup-table. Additionally, various disclosures provide for transfer functions of any order, type, or family. One disclosure of a transfer curve is sum of conductance vs. liquid volume (e.g., Ti(mL, Siemens)).

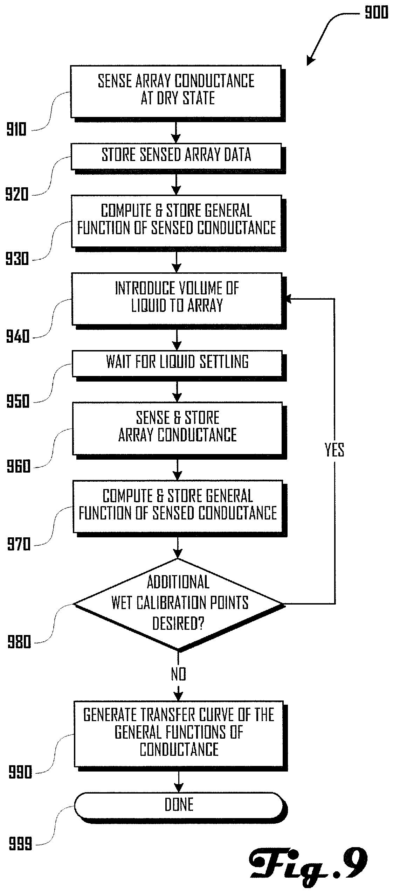

Fig. 9 is an exemplary flow chart illustrating a method 900 for calibrating a fluid sensor 100. The method 900 begins in block 910, where the conductance of an array 100 is sensed at a dry state. For example, the conductance of an array 100 may be sensed via the sensing method 700 of Fig. 7. Other electrical characteristics such as resistance or capacitance may be measured in addition or alternatively.

Returning to Fig. 9, the sensed array data is stored in block 920, and in block 930, a general function of the sensed conductance is computed and stored. In block 840, a volume of liquid is introduced to the array 100 and a time period is allowed to lapse, which provides for liquid settling in block 950. A settling time may be chosen based on the properties of various components of an array 100, including the buffer layer 160, conducting lines 110, 130, the fluid layer 120, or the like.

In block 960, array conductances are sensed in a wet state and stored, and in block 970, a general function of the sensed conductance is computed and stored. In decision block 980, a determination is made whether additional wet calibration points are desired, and if so, the method 900 cycles back to block 940, where a further volume of liquid is introduced to the array 100. However, if no further additional wet calibration points are desired, then the method 900 continues to block 990 where a transfer curve of the general functions (*e.g., f₂(m, n)*) is generated, and in block 999, the method 900 is done.

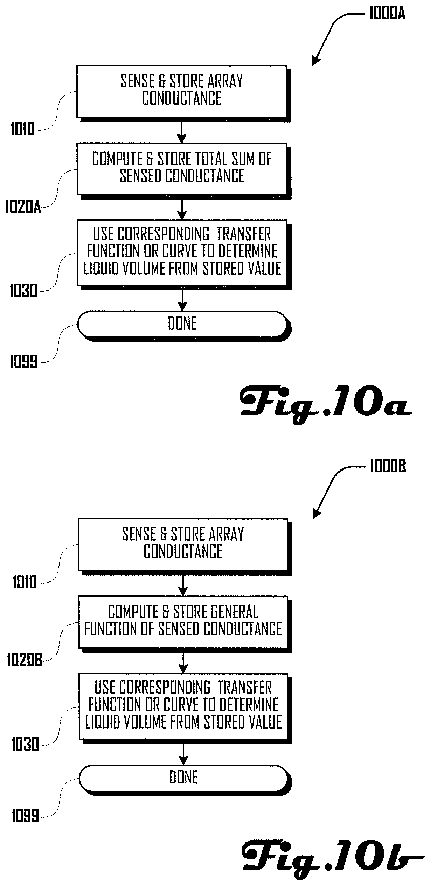

Fig. 10a depicts method 1000Aof determining fluid volume in accordance with a first embodiment. Fig. 10b depicts method 1000B of determining fluid volume in accordance with a first disclosure. The methods 1000A, 1000B begin in block 1010, where array conductance is sensed and stored, which may be performed according to the method 700 of Fig. 7, or the like.

Fig. 10a depicts a method 1000A wherein a total sum of sensed conductance is computed and stored, in block 1020A. Fig. 10b depicts a method 1000B wherein a general function of the sensed conductance is computed and stored, in block 1020B. In block 1030, the stored value is compared to a corresponding transfer function or curve to determine a value for volume of liquid, and the methods 1000A, 1000B are done in block 1099.

As discussed relation to Figs. 7 and 8, a transfer curve or function may be generated based on total sum of conductances vs. liquid volume, or may be generated based on general function of conductances vs. liquid volume. Accordingly, one or both of such transfer curves or functions may be used to then determine a value for liquid volume based on sensed conductance of an array 100.
A moisture sensing array 100 may be used to calculate a surface area of array 100 where fluid is present or absent at a given threshold. For example, data obtained from the array 100 can be filtered to identify sensing regions 150 where fluid is detected at a threshold level, and this can be converted into a value for surface area of the array 100 with fluid present, by assigning a surface area value to each sensing

region 150 where fluid is detected at a threshold level. Additionally, in some embodiments, such a surface area calculation may be combined with a volume calculation (*e.g.,* Fig. 10a) to provide a value for volume of fluid in a given surface area. Additionally, in some disclosures, such a surface area calculation may be combined with a volume calculation (*e.g.*, Fig. 10b) to provide a value for volume of fluid in a given surface area.

Additionally, an array 100 may be used to determine the identity of a fluid present in the array 100 or determine the type or class of fluid present in the array 100. For example, a determination may be made whether the fluid present is a gas or liquid; whether the fluid present is hydrophobic or hydrophilic; whether the fluid is water-based; whether the fluid comprises urine; whether the fluid comprises sweat; or the like.

For example, the variation in the conductivity of different liquids can provide the ability for the array 100 to sense and identify contact between a liquid and one or more sensing regions 150. Conductivity can also be measured based on the material in which the sensor array 100 is contained when moisture is detected. The array 100 can also measure both instantly and over time, values for viscosity, permeability, and conductivity, to identify a liquid. Control values for certain liquids can also be established such that the array compares real-time data with reference values. Individual analyses of liquid for identification can also be combined with surface area and volume measurements above, plus other standard parameters such as temperature, pressure, and motion.

The described embodiments are susceptible to various modifications and alternative forms, and specific examples thereof have been shown by way of example in the drawings and are herein described in detail.

## Claims

1. A diaper with a liquid sensing system comprising:
a sensor array comprised of a set of elongated and flat uniformly shaped conducting lines (210, 220), wherein the conducting lines are uniform in shape and substantially parallel extending along an inner surface of a moisture barrier layer (230), wherein the sensor array has a measured gradient of conductance in a dry state;
wherein a pair of the conducting lines (210, 220) define an array sensing region (200) that is configured for measuring a gradient of conductance values in the sensing region upon a presence of a liquid contained by the moisture barrier layer (230);
a data acquisition unit (510) operably connected to the sensor array comprising signal processing elements, wherein the data acquisition unit (510) comprises
a multiplexer (610) configured for receiving analog voltage signals from the array sensing region (200) of the sensor array and measuring the gradient of conductance values between each of the pair of conducting lines (210, 220) defining the array sensing region (200),
a read circuit (620) configured for measuring the voltage signals, and
an analog to digital converter (630) configured for converting the voltage signals to numeric representation and combinations thereof.

2. The diaper with a liquid sensing system of claim 1, wherein the pair of conducting lines (210, 220) define a sensing region there between, preferably wherein there is a storable data identifier unique to the array sensing region (200).

3. The diaper with a liquid sensing system of claim 1, wherein the data acquisition unit (510) is connected by wire to the sensor array to a user device (520).

4. The diaper with a liquid sensing system of claim 1, wherein the data acquisition unit (510) stores sensed conductance gradient values.

5. The diaper with a liquid sensing system of claim 1, further comprising a network connection to a user device (520) selected from a group consisting of a tablet, a smart phone, and a computer.

6. The diaper with a liquid sensing system of claim 1, further comprising a fluid active material (250) disposed in proximity to the sensor array to alter electrical characteristics of the fluid contained by the moisture barrier layer (230).

7. The diaper of claim 1, wherein the array sensing region (200) measures a gradient of dry state conductance values and a gradient of wet state conductance values in the sensing region upon a presence of a liquid contained by the moisture barrier layer (230).

8. A method for detection of liquid disposed in a diaper, the method comprising:
operably connecting a data acquisition unit (510) to a diaper which comprises a moisture barrier layer (230);
sensing array conductance in a dry state by measuring a gradient of conductance values in an array sensing region (200) of substantially parallel conducting lines (210, 220) disposed along a surface of the moisture barrier layer (230) and storing the sensed array conductance in the dry state, wherein an area between a pair of conducting lines defines the array sensing region (200);
computing and storing a total sensed array conductance in the dry state;
detecting a change in the gradient of conductance values at a plurality of the sensing regions in the array sensing region in response to the presence of a liquid;
computing and storing a total sum of sensed conductance in the wet state;
using a transfer curve to determine a liquid volume from the total, stored sensed conductance in the wet state;
wherein the gradient of conductance values of the conducting lines (210, 220) are communicated to the data acquisition unit (510) such that each of the plurality of sensing regions has a storable data identifier, and wherein a detectable signal is processed in the data acquisition unit (510);
storing sensed data from a array sensing region (200) having the storable data identifier;
repeating each of the measuring, detecting, and storing steps for a plurality of the sensing regions of the array sensing region (200); and
calculating a volume of liquid contained by the moisture barrier layer (230) based on the gradient of conductance values detected at the plurality of sensing regions in the array sensing region (200) and communicated to the data acquisition unit (510).

9. The method of claim 8, wherein the measuring, detecting and storing steps comprise a sensing session and the method further comprises the step of determining whether the sensing session is complete or repeated.

10. The method of claim 8, wherein the calculating step is further comprised of determining whether a threshold fluid limit is met, preferably wherein the step of calculating a volume of liquid contained by the moisture barrier layer (230) is comprised of
measuring real time, sensed gradient conductance values against a calibrated reference value.

11. The method of claim 8, wherein the measuring step is comprised of measuring the gradient of conductance values in the array sensing region (200) in a dry state and storing the dry state value, or measuring a gradient of conductance values in a plurality of wet states, preferably further comprising the step of storing a total sum of the plurality of wet state conductance values.

12. The method of claim 8, further comprising the step of calculating a surface area of the array sensing region (200) where liquid is present, preferably wherein the calculation of surface area is combined with the calculation of volume to yield a value for volume of liquid in a selected surface area.

13. The method of claim 8, wherein the data acquisition unit (510) further comprises a multiplexer (610), wherein the multiplexer (610) obtains a signal from the array sensing region (200), provides the signal to a read circuit (620), and converts the signal from analog to digital with an analog to digital converter (630).

## Patentansprüche

1. Windel mit einem Flüssigkeitsdetektionssystem, umfassend:
ein Sensorarray, das aus einem Satz von länglichen und flachen, gleichmäßig geformten stromführenden Leitungen (210, 220) besteht, wobei die stromführenden Leitungen eine gleichmäßige Form aufweisen und sich im Wesentlichen parallel entlang einer Innenfläche einer Feuchtigkeitssperrschicht (230) erstrecken, wobei das Sensorarray einen gemessenen Gradienten der Leitfähigkeit in einem trockenen Zustand aufweist;
wobei ein Paar der stromführenden Leitungen (210, 220) einen Arraydetektionsbereich (200) definiert, der zum Messen eines Gradienten von Leitfähigkeitswerten in dem Detektionsbereich bei Vorhandensein einer Flüssigkeit, die durch die Feuchtigkeitssperrschicht (230) gehalten wird, konfiguriert ist;
eine mit dem Sensorarray wirkverbundene Datenerfassungseinheit (510), die Signalverarbeitungselemente umfasst, wobei die Datenerfassungseinheit (510) Folgendes umfasst:
einen Multiplexer (610), der zum Empfangen von analogen Spannungssignalen von dem Arraydetektionsbereich (200) des Sensorarrays und zum Messen des Gradienten von Leitfähigkeitswerten zwischen jeder des Paars von stromführenden Leitungen (210, 220), das den Arraydetektionsbereich (200) definiert, konfiguriert ist,
eine Leseschaltung (620), die zum Messen der Spannungssignale konfiguriert ist, und
einen Analog-Digital-Wandler (630), der zum Umwandeln der Spannungssignale in numerische Darstellung und Kombinationen davon konfiguriert ist.

2. Windel mit einem Flüssigkeitsdetektionssystem nach Anspruch 1, wobei das Paar von stromführenden Leitungen (210, 220) einen Detektionsbereich dazwischen definiert, wobei vorzugsweise eine speicherbare Datenkennung vorhanden ist, die für den Arraydetektionsbereich (200) eindeutig ist.

3. Windel mit einem Flüssigkeitsdetektionssystem nach Anspruch 1, wobei die Datenerfassungseinheit (510) drahtgebunden mit dem Sensorarray mit einer Benutzervorrichtung (520) verbunden ist.

4. Windel mit einem Flüssigkeitsdetektionssystem nach Anspruch 1, wobei die Datenerfassungseinheit (510) detektierte Leitfähigkeitsgradientenwerte speichert.

5. Windel mit einem Flüssigkeitsdetektionssystem nach Anspruch 1, ferner umfassend eine Netzwerkverbindung mit einer Benutzervorrichtung (520), die aus einer Gruppe ausgewählt ist, die aus einem Tablet, einem Smartphone und einem Computer besteht.

6. Windel mit einem Flüssigkeitsdetektionssystem nach Anspruch 1, ferner umfassend ein fluidaktives Material (250), das in der Nähe des Sensorarrays angeordnet ist, um elektrische Eigenschaften des Fluids, das durch die Feuchtigkeitssperrschicht (230) gehalten wird, zu ändern.

7. Windel nach Anspruch 1, wobei der Arraydetektionsbereich (200) einen Gradienten von Leitfähigkeitswerten im trockenen Zustand und einen Gradienten von Leitfähigkeitswerten in nassem Zustand in dem Detektionsbereich bei Vorhandensein einer Flüssigkeit, die durch die Feuchtigkeitssperrschicht (230) gehalten wird, misst.

8. Verfahren zur Erkennung von in einer Windel angeordneter Flüssigkeit, wobei das Verfahren Folgendes umfasst:
Wirkverbinden einer Datenerfassungseinheit (510) mit einer Windel, die eine Feuchtigkeitssperrschicht (230) umfasst;
Detektieren der Arrayleitfähigkeit in einem trockenen Zustand durch Messen eines Gradienten von Leitfähigkeitswerten in einem Arraydetektionsbereich (200) aus im Wesentlichen parallelen stromführenden Leitungen (210, 220), die entlang einer Oberfläche der Feuchtigkeitssperrschicht (230) angeordnet sind, und Speichern der detektierten Arrayleitfähigkeit im trockenen Zustand, wobei eine Fläche zwischen einem Paar von stromführenden Leitungen den Arraydetektionsbereich (200) definiert;
Berechnen und Speichern einer gesamten detektierten Arrayleitfähigkeit im trockenen Zustand;
Erkennen einer Änderung des Gradienten von Leitfähigkeitswerten an einer Vielzahl von Detektionsbereichen in dem Arraydetektionsbereich als Reaktion auf das Vorhandensein einer Flüssigkeit;
Berechnen und Speichern einer Gesamtsumme der detektierten Leitfähigkeit im nassen Zustand;
Verwenden einer Übertragungskurve, um ein Flüssigkeitsvolumen aus der gesamten, gespeicherten, detektierten Leitfähigkeit im nassen Zustand zu bestimmen;
wobei der Gradient von Leitfähigkeitswerten der stromführenden Leitungen (210, 220) an die Datenerfassungseinheit (510) derart übermittelt wird, dass jeder der Vielzahl von Detektionsbereichen eine speicherbare Datenkennung aufweist, und wobei ein erkennbares Signal in der Datenerfassungseinheit (510) verarbeitet wird;
Speichern von detektierten Daten aus einem Arraydetektionsbereich (200), der die speicherbare Datenkennung aufweist;
Wiederholen jedes der Schritte des Messens, Erkennens und Speicherns für eine Vielzahl der Detektionsbereiche des Arraydetektionsbereichs (200); und
Berechnen eines durch die Feuchtigkeitssperrschicht (230) gehaltenen Flüssigkeitsvolumens basierend auf dem Gradienten von Leitfähigkeitswerten, der an der Vielzahl von Detektionsbereichen in dem Arraydetektionsbereich (200) erkannt und an die Datenerfassungseinheit (510) übermittelt wird.

9. Verfahren nach Anspruch 8, wobei die Schritte des Messens, Erkennens und Speicherns eine Detektionssitzung umfassen und das Verfahren ferner den Schritt des Bestimmens, ob die Detektionssitzung abgeschlossen ist oder wiederholt wird, umfasst.

10. Verfahren nach Anspruch 8, wobei der Berechnungsschritt ferner aus einem Bestimmen besteht, ob eine Schwellenfluidgrenze erfüllt ist, wobei der Schritt des Berechnens eines durch die Feuchtigkeitssperrschicht (230) gehaltenen Flüssigkeitsvolumens vorzugsweise aus
Messen von detektierten Gradientenleitfähigkeitswerten in Echtzeit gegenüber einem kalibrierten Referenzwert besteht.

11. Verfahren nach Anspruch 8, wobei der Messschritt aus einem Messen des Gradienten von Leitfähigkeitswerten in dem Arraydetektionsbereich (200) in einem trockenen Zustand und Speichern des Werts im trockenen Zustand oder einem Messen eines Gradienten von Leitfähigkeitswerten in einer Vielzahl von nassen Zuständen besteht, vorzugsweise ferner umfassend den Schritt des Speicherns einer Gesamtsumme der Vielzahl von Leitfähigkeitswerten im nassen Zustand.

12. Verfahren nach Anspruch 8, ferner umfassend den Schritt des Berechnens eines Oberflächenbereichs des Arraydetektionsbereichs (200), wo Flüssigkeit vorhanden ist, wobei die Berechnung des Oberflächenbereichs vorzugsweise mit der Berechnung des Volumens kombiniert wird, um einen Wert für das Flüssigkeitsvolumen in einem ausgewählten Oberflächenbereich zu ergeben.

13. Verfahren nach Anspruch 8, wobei die Datenerfassungseinheit (510) ferner einen Multiplexer (610) umfasst, wobei der Multiplexer (610) ein Signal von dem Arraydetektionsbereich (200) erlangt, das Signal an eine Leseschaltung (620) bereitstellt und das Signal mit einem Analog-Digital-Wandler (630) von analog zu digital umwandelt.

## Revendications

1. Couche-culotte ayant un système de détection de liquide comprenant :
un réseau de capteurs constitué d'un ensemble de lignes conductrices (210, 220) allongées et plates de forme uniforme, dans laquelle les lignes conductrices ont une forme uniforme et s'étendent sensiblement parallèlement le long d'une surface interne d'une couche barrière contre l'humidité (230), dans laquelle le réseau de capteurs présente un gradient de conductance mesuré à l'état sec ;
dans laquelle une paire de lignes conductrices (210, 220) définissent une région de détection de réseau (200) qui est configurée pour mesurer un gradient de valeurs de conductance dans la région de détection lors de la présence d'un liquide contenu par la couche barrière contre l'humidité (230) ;
une unité d'acquisition de données (510) connectée fonctionnellement au réseau de capteurs comprenant des éléments de traitement de signal, dans laquelle l'unité d'acquisition de données (510) comprend
un multiplexeur (610) configuré pour recevoir des signaux de tension analogiques provenant de la région de détection de réseau (200) du réseau de capteurs et mesurer le gradient de valeurs de conductance entre chacune de la paire de lignes conductrices (210, 220) définissant la région de détection de réseau (200),
un circuit de lecture (620) configuré pour mesurer les signaux de tension, et
un convertisseur analogique-numérique (630) configuré pour convertir les signaux de tension en représentation numérique et leurs combinaisons.

2. Couche-culotte ayant un système de détection de liquide selon la revendication 1, dans laquelle la paire de lignes conductrices (210, 220) définissent une région de détection entre elles, de préférence dans laquelle il existe un identifiant de données pouvant être stocké unique à la région de détection de réseau (200).

3. Couche-culotte ayant un système de détection de liquide selon la revendication 1, dans laquelle l'unité d'acquisition de données (510) est connectée par fil au réseau de capteurs à un dispositif utilisateur (520).

4. Couche-culotte ayant un système de détection de liquide selon la revendication 1, dans laquelle l'unité d'acquisition de données (510) stocke des valeurs de gradient de conductance détectées.

5. Couche-culotte ayant un système de détection de liquide selon la revendication 1, comprenant également une connexion réseau à un dispositif utilisateur (520) choisi dans le groupe constitué d'une tablette, d'un téléphone intelligent et d'un ordinateur.

6. Couche-culotte ayant un système de détection de liquide selon la revendication 1, comprenant également une matière active fluide (250) disposée à proximité du réseau de capteurs pour modifier des caractéristiques électriques du fluide contenu par la couche barrière contre l'humidité (230).

7. Couche-culotte selon la revendication 1, dans laquelle la région de détection de réseau (200) mesure un gradient de valeurs de conductance à l'état sec et un gradient de valeurs de conductance à l'état humide dans la région de détection lors de la présence d'un liquide contenu par la couche barrière contre l'humidité (230).

8. Procédé de détection d'un liquide disposé dans une couche-culotte, le procédé comprenant :
la connexion fonctionnelle d'une unité d'acquisition de données (510) à une couche-culotte qui comprend une couche barrière contre l'humidité (230) ;
la mesure d'une conductance de réseau à l'état sec en mesurant un gradient de valeurs de conductance dans une région de détection de réseau (200) de lignes conductrices sensiblement parallèles (210, 220) disposées le long d'une surface de la couche barrière contre l'humidité (230) et le stockage de la conductance de réseau détectée à l'état sec, dans lequel une zone entre une paire de lignes conductrices définit la région de détection de réseau (200) ;
le calcul et le stockage d'une conductance totale de réseau détectée à l'état sec ;
la détection d'un changement du gradient de valeurs de conductance au niveau d'une pluralité des régions de détection dans la région de détection de réseau en réponse à la présence d'un liquide ;
le calcul et le stockage d'une somme totale de conductance détectée à l'état humide ;
l'utilisation d'une courbe de transfert pour déterminer un volume de liquide à partir de la conductance totale détectée et stockée à l'état humide ;
dans lequel le gradient de valeurs de conductance des lignes conductrices (210, 220) est communiqué à l'unité d'acquisition de données (510) de sorte que chacune de la pluralité de régions de détection présente un identifiant de données pouvant être stocké, et dans lequel un signal détectable est traité dans l'unité d'acquisition de données (510) ;
le stockage de données détectées provenant d'une région de détection de réseau (200) ayant l'identifiant de données pouvant être stocké ;
la répétition de chacune des étapes de mesure, de détection et de stockage pour une pluralité des régions de détection de la région de détection de réseau (200) ; et
le calcul d'un volume de liquide contenu par la couche barrière contre l'humidité (230) sur la base du gradient de valeurs de conductance détectées au niveau de la pluralité de régions de détection dans la région de détection de réseau (200) et communiquées à l'unité d'acquisition de données (510).

9. Procédé selon la revendication 8, dans lequel les étapes de mesure, de détection et de stockage comprennent une session de détection et le procédé comprend également l'étape de détermination du fait de savoir si la session de détection est complète ou répétée.

10. Procédé selon la revendication 8, dans lequel l'étape de calcul consiste en outre à déterminer le fait de savoir si une limite de fluide seuil est atteinte, de préférence dans lequel l'étape de calcul d'un volume de liquide contenu par la couche barrière contre l'humidité (230) consiste à
mesurer, en temps réel, des valeurs de conductance de gradient détectées par rapport à une valeur étalonnée de référence.

11. Procédé selon la revendication 8, dans lequel l'étape de mesure consiste à mesurer le gradient de valeurs de conductance dans la région de détection de réseau (200) à l'état sec et à stocker la valeur d'état sec, ou à mesurer un gradient de valeurs de conductance dans une pluralité d'états humides, comprenant également de préférence l'étape de stockage d'une somme totale de la pluralité de valeurs de conductance à l'état humide.

12. Procédé selon la revendication 8, comprenant également l'étape de calcul d'une surface de la région de détection de réseau (200) où se trouve un liquide, de préférence dans lequel le calcul de surface est combiné avec le calcul de volume pour donner une valeur de volume de liquide dans une surface sélectionnée.

13. Procédé selon la revendication 8, dans lequel l'unité d'acquisition de données (510) comprend également un multiplexeur (610), dans lequel le multiplexeur (610) obtient un signal provenant de la région de détection de réseau (200), fournit le signal à un circuit de lecture (620), et convertit le signal d'analogique en numérique avec un convertisseur analogique-numérique (630).
